(19) Europäisches Patentamt
European Patent Office
Office européen des brevets

(11) **EP 2 022 165 B1**

(12) **EUROPEAN PATENT SPECIFICATION**

(45) Date of publication and mention
of the grant of the patent:
**11.01.2012 Bulletin 2012/02**

(51) Int Cl.:
*H03B 19/03* (2006.01)    *H03K 3/80* (2006.01)
*H01R 13/7197* (2011.01)

(21) Application number: **07733741.8**

(22) Date of filing: **06.06.2007**

(86) International application number:
**PCT/GB2007/050320**

(87) International publication number:
**WO 2007/141576 (13.12.2007 Gazette 2007/50)**

(54) **RADIO FREQUENCY AND MICROWAVE GENERATOR**

FUNKFREQUENZ- UND MIKROWELLENGENERATOR

GÉNÉRATEUR DE FRÉQUENCES RADIO ET DE MICRO-ONDES

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **08.06.2006 GB 0611358**
**20.07.2006 GB 0614758**

(43) Date of publication of application:
**11.02.2009 Bulletin 2009/07**

(73) Proprietor: **BAE Systems PLC**
**London SW1Y 5AD (GB)**

(72) Inventors:
• **SEDDON, Nigel**
**Filton Bristol BS34 7QW (GB)**
• **DOLAN, John Eric**
**Filton Bristol BS34 7QW (GB)**

(74) Representative: **McBrien, Matthew Nicholas**
**BAE Systems plc**
**Group Intellectual Property Department**
**P.O. Box 87**
**Warwick House**
**Farnborough Aerospace Centre**
**Farnborough**
**Hampshire GU14 6YU (GB)**

(56) References cited:
**DE-B- 1 227 085**    **US-A- 2 871 453**
**US-A- 4 719 429**

• **DOLAN J E: "SIMULATION OF SHOCK WAVES IN FERRITE-LOADED COAXIAL TRANSMISSION LINES WITH AXIAL BIAS" JOURNAL OF PHYSICS D. APPLIED PHYSICS, IOP PUBLISHING, BRISTOL, GB, vol. 32, no. 15, 7 August 1999 (1999-08-07), pages 1826-1831, XP000923839 ISSN: 0022-3727**
• **KALINIKOS B A ET AL: "Generation of short millimeter-wave radio pulses using solitons in ferrite-based active rings" APPLIED PHYSICS LETTERS, AIP, AMERICAN INSTITUTE OF PHYSICS, MELVILLE, NY, US, vol. 79, no. 10, 3 September 2001 (2001-09-03), pages 1576-1578, XP012028837 ISSN: 0003-6951**
• **WILSON C R ET AL: "PULSE SHARPENING IN A UNIFORM LC LADDER NETWORK CONTAINING NONLINEAR FERROELECTRIC CAPACITORS" IEEE TRANSACTIONS ON ELECTRON DEVICES, IEEE SERVICE CENTER, PISACATAWAY, NJ, US, vol. 38, no. 4, 1 April 1991 (1991-04-01), pages 767-771, XP000177970 ISSN: 0018-9383**

## Description

This invention relates to Radio Frequency (RF) and microwave signals and in particular the generation of high power microwave signals for use in high resolution radar applications.

Two types of waveform are well known in the field of high-power microwave technology. Firstly, short duration unipolar electrical impulses, commonly referred to as UltraWideBand (UWB) pulses, can be produced. UWB pulses have large instantaneous Fourier bandwidths: the energy in this type of waveform is distributed across a wide range of frequencies and the energy density at any one particular frequency is small. UWB pulses find application in communication systems and in radar systems. Conventionally, the UWB pulse is delivered to an antenna and a signal having a wide range of frequency components is radiated.

Secondly, high power microwave waveforms consisting of a large number (greater than 10) of cycles of radiation can be produced. Conventionally, this type of waveform is produced by a large electron beam machine consisting of a high voltage pulsed power supply, a cathode, an electron drift tube, an electron modulation region and an antenna. This type of high power microwave signal may be used for heating of materials or plasmas and for energy transport.

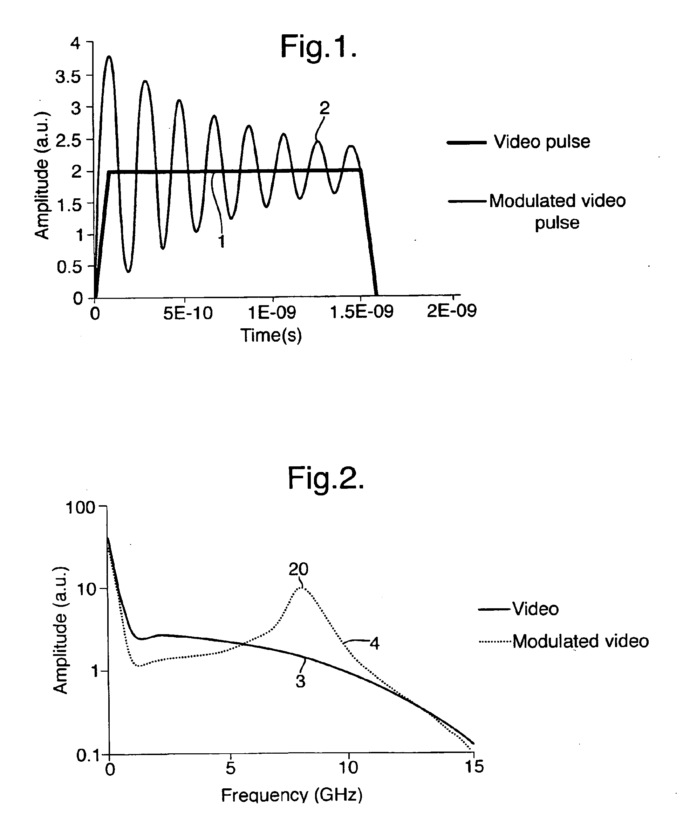

Both the above methods of producing high-power microwave signals have disadvantages that limit the performance, or application, of the technology. In the case of a UWB waveform, the spectral energy content of a radiated pulse is defined by the characteristics of the unipolar electric impulse and the antenna that is used to radiate the UWB impulse. For example the video pulse 1 shown in Figure 1 is a unipolar electric impulse with a risetime of 0.1 nanoseconds and 5ns pulse duration. The corresponding Fourier transform of this video pulse is shown as 3 in Figure 2. It is apparent that the majority of the energy is contained in lower frequency spectral components, whilst relatively little energy is contained in higher frequency components. It is clear that while UWB pulse generators can produce high power microwave radiation the spectral energy density at any given frequency in the microwave region of the spectrum is small.

The second type of high power microwave source, which is based on high-power electron beams, also has operation limitations. This type of microwave source can produce very high energy densities in the microwave region of the spectrum. However, these sources are usually very large, frequently require ancillary vacuum and cryogenic systems, and may produce x-rays. They are therefore impractical for use outside a laboratory environment.

Shaw H.J., Elliott, B.J., Harker K.J., and Karp A., Microwave generation in pulsed ferrites, J. App. Phys., Vol 37, No. 3, 1966 details a method for converting energy from a pulsed magnetic field to a microwave signal in a waveguide. Shaw's 'Pulsed Magnetic Microwave Generator' relies on impulse-driven gyromagnetic precession in a small Yttrium Iron Garnet (YIG) sphere to convert energy from a 'pump pulse' to a microwave signal. A small spherical (approximately 1 mm diameter) specimen of magnetic material is placed in a microwave waveguide cavity. A strong, constant magnetic bias field is applied to the magnetic sphere in order to align magnetic moments within the magnetic material. Subsequently a strong pulsed magnetic field is applied to the sphere at some angle to the constant bias field. The pulsed magnetic field causes realignment of the magnetisation vector in the sphere on a timescale that is similar to the rise time of the pulsed field. If the rise time is sufficiently short the magnetisation vector does not simply follow the pulsed field but precesses around the direction of the applied field. This gyromagnetic precession persists for a time that is related to damping processes in the r ,agnetic material. The precessing magnetisation vector in the magnetic material constitutes an oscillator at the gyromagnetic precession frequency. The magi etic sphere is located in a waveguide cavity so that energy from the gyromagnetic oscillator is coupled into the waveguide as an electromagnetic signal. Consequently the magnetic sphere is used as an impulse-excited transducer that converts energy from the pulsed magnetic field to a microwave signal in the waveguide.

Disadvantages of this method of generation of microwave signals include : the amount of energy and power that can be converted to a microwave signal is limited by the requirement for a small spherical specimen of magnetic material, usually YIG, to achieve fully temporally and spatially coherent precession and, because the pulsed magnetic field is produced by passing a large pulsed current through an external coil, the ratio of microwave energy produced to the energy stored in the coil is inherently low, as the pulsed magnetic field is applied to a large volume compared to the volume of the sphere.

Simulation of Shock Waves in Ferrite-Loaded Coaxial Transmission Lines with Axial Bias (Dolan J E, Journal of Physics D and Applied Physics, vol. 32, no. 15, 7 August 1999, pages 1826-1831) presents a model for shock wave development in axially-biased ferrite-loaded coaxial lines. However, this model is associated with a minimum usable pulse amplitude and consequently its applications are limited.

There is a thus need for new sources of microwave and RF radiation that are capable of producing high-power signals more efficiently than presently known sources.

Accordingly, it is an object of the present invention to provide an alternative method and apparatus for generating pulsed RF or microwave signals.

In broad terms, the invention is a method that produces an RF or microwave signal by modulating the amplitude of an electrical impulse. Furthermore, in broad terms, the invention also resides in a signal generator comprising suitable electrical and magnetic components configured to produce an RF or microwave signal. A transmission line containing a magnetic material with low-loss gyromagnetic characteristics is used. An electrical impulse is injected in to this transmission line in order to induce low loss gyromagnetic precession in the magnetic material, which in turn modulates the amplitude of the electrical impulse at the gyromagnetic precession frequency. Modulation of the electrical impulse at the precession frequency produces significant energy at this frequency which can then be extracted and may be radiated using a suitable antenna.

According to a first aspect of the present invention there is provided a RF or microwave signal generator comprising a video pulse generator and a transmission line modulator configured to modify the generated video pulses by impulse-excited gyromagnetic precession. This will transfer a portion of the video pulse energy from low frequencies to RF or microwave frequencies thereby producing a resultant waveform with a RF and/or microwave component. The video pulse is an electrical impulse that is injected in to the transmission line in order to induce low loss gyromagnetic precession in a magnetic material forming part of the transmission line. The precession in turn modulates the amplitude of the electrical impulse at the gyromagnetic precession frequency. Magnetic material may be distributed along the entire length of the transmission line such that the electrical impulse has an extended interaction therewith as it propagates along the transmission line. An external magnetic field may be applied to the transmission line which may have components axially or otherwise orientated to the transmission line. Modulation of the electrical impulse at the gyromagnetic precession frequency produces significant energy at this frequency.

In this context a video pulse is defined as an electrical pulse with short rise-time relative to the pulse width, and a substantially constant amplitude over the pulse duration. When a video pulse is fed into a suitable antenna an Ultra Wide Band (UWB) pulse may be radiated. UWB waveforms are of interest for high resolution radar applications because their short pulse duration can provide a good target resolution, and the very broad spectral energy content has potential to be coupled with a wide range of features on a target. However, the majority of the energy in a video pulse waveform is contained in spectral components below the 100 MHz region and so is not radiated in the UWB waveform.

It has been found that modulating the video pulse at a suitable frequency produces a modulated pulse having a significant energy content shift to the radio and/or microwave frequencies, representing a major increase in the energy that can be radiated by the antenna. Thus the modulation to the waveform allows the radiated signal to be focused to a greater degree and increases the radiated field that can be produced at a large distance from the source.

Preferably the modulator includes a non-linear transmission line containing magnetic material, further preferably having strong gyromagnetic characteristics.

As the RF wave and/or microwave modulation is produced in a travelling wave manner, this largely removes the restriction on the magnetic material volume suffered by the prior art, allowing larger power levels to be generated.

This design allows a physically and electrically extended interaction to be achieved between the electrical impulse and the magnetic material. The advantages of this scheme are that a significantly larger volume of magnetic material can be excited by a travelling wave in a transmission line, and the energy in the electrical impulse is used more effectively. As a consequence the energy conversion efficiency of this device is considerably higher than that achieved by prior known devices, such as the device disclosed by Shaw et al. The microwave signal that is generated by gyromagnetic precession in the magnetic material is supported by the transmission line and appears as a modulation on the electrical impulse pulse; consequently a separate waveguide is not required to extract the RF and/or microwave signal.

Non-linear material can be used to form electromagnetic shock waves in transmission lines, for example, coaxial transmission lines as outlined by Katayev, I.G., 'Electromagnetic shock waves', Iliffe Books Ltd., 1966, and also Weiner M. and Silber L. 'Pulse sharpening effects in ferrites', IEEE Trans Magn 1981, MAG-17, pp1472-1477. Transmission lines may contain saturable magnetic materials and be used to produce electrical impulses with short pulse rise times. These devices exploit magnetic non-linearity of the magnetic material to form an 'electromagnetic shock wave' that is a very rapid change in electric and magnetic fields within the transmission line. The rate of change of these fields is determined by the limiting dynamic response of the magnetic material to strong applied fields. In practical embodiments of these devices an electrical impulse is injected into a coaxial transmission line containing the magnetic material. As the electrical pulse propagates along the transmission line the leading edge of the input pulse is modified by the magnetic non-linearity, the rise-time pulse becoming progressively shorter until the limiting response time is achieved. Once the limiting response time is achieved the pulse continues to propagate with this rise-time. This type of electromagnetic shock line can be used to form video pulses with sub-nanosecond rise-times.

The transmission line embodiment of this invention allows a high power video pulse source to be modified to give the waveform and frequency characteristics of a pulsed RF or microwave source.

The electrical and magnetic characteristics of the non-linear transmission line, and the materials of construction, are selected to produce strong gyromagnetic precession of the magnetisation within the magnetic components when an electrical impulse is injected into the transmission line. The induced gyromagnetic precession influences the propagation of the injected electrical impulse and modulates the impulse at RF and/or microwave frequencies. The characteristics of the modulation are determined by the design of the non-linear transmission line and by the selection of suitable magnetic materials. Suitable magnetic materials are expected to exhibit strong low-loss gyromagnetic behaviour.

The transmission line may comprise a magnetic material having low gyromagnetic damping. The magnetic material may be a garnet structured ferrite material such as yttrium iron garnet.

The impulse generator may produce a pumping impulse. The pumping impulse may have a rise time that is a fraction of the period of the resultant RF or microwave waveform. This design allows a physically and electrically extended interaction to be achieved between the pumping signal and the magnetic material. The advantages of this scheme are that a significantly larger volume of magnetic material can be excited by a travelling wave in a transmission line, and the energy in the pumping pulse is used more effectively. As a consequence the energy conversion efficiency of this device is considerably higher than that achieved by the prior art. The RF signal and/or microwave signal that is generated by gyromagnetic precession in the magnetic material is supported by the transmission line and appears as a modulation on the pumping video pulse; consequently a separate waveguide is not required to extract the RF and/or microwave signal.

The spectral profile of the resultant output pulse may be determined by tuning frequency output by adjusting the frequency at which the video pulses are modulated by varying the amplitude of the constant axial magnetic field $H_{ax}$, and/or the amplitude of the pumping impulse and/or the dimensions of the magnetic material and of the coaxial structure.

An external magnetic field may be applied to the transmission line. This magnetic field may have components axially or otherwise orientated to the transmission line. Preferably the transmission line comprises low dielectric loss insulators such as polytetrafluroethylene (PTFE) or polypropylene. The transmission line may have conductors made from copper, silver or gold or other high conductivity materials to minimise resistive dissipation.

According a second aspect of the invention there is provided an antenna having a microwave signal generator as previously described.

According to a third aspect of the invention there is provided a method for generating microwave signals including the steps of:

generating short rise-time video pulses; and

modifying the video pulses' energy from frequencies below the RF or microwave range to frequencies in the RF or microwave range

thereby producing a resultant waveform with an RF or microwave component.

The video pulses may be passed through a transmission line comprising a magnetic material having low gyromagnetic damping. The method may further comprise the step of applying a magnetic field to the magnetic material, which magnetic field is orientated axially relative to the transmission line. The magnetic field is preferably sufficiently strong to cause greater than 99% alignment of the magnetic movements of the magnetic material.

The invention will now be further described by way of example only and with reference to the accompanying drawings of which:

Figure 1 shows a graphical comparison of the temporal waveforms of a video waveform and a suitably modulated video waveform to cause a significant energy content shift to the microwave frequencies;

Figure 2 shows the Fourier spectrums associated with the video waveform and modulated video waveform of Figure 1;

Figure 3 shows a schematic diagram of an apparatus for generating microwave signals in accordance with the invention;

Figure 4 shows in detail the geometric disposition of the coaxial transmission line structure and the magnetic material used in the apparatus of Figure 3;

Figure 5 is a schematic representation of the magnetic field applied to the non-linear transmission line of Figure 4.

Figure 1 compares the time waveform of a typical electrical video impulse 1, with a 0.1ns rise time and a 1.5ns pulse duration and the time waveform of a microwave modulated pulse 2. The electrical video pulse might typically be used to drive a UWB antenna directly. Figure 2 shows the Fourier spectrums of the unmodulated video pulse waveform 3, and microwave modulated waveform 4. From Figure 2 it can be seen that the majority of energy in the video pulse 1 is contained in spectral components below the 100MHz region and that there is very little energy in the higher frequency components. Thus a large portion of the components of the video pulse would not be radiated by an antenna because most of the components would have a frequency below the cut-off of the antenna.

However, the Fourier spectrum of the modulated waveform 4 shows a major peak 20 at the modulation frequency. This represents energy shifted from the video frequencies up to the microwave frequencies and a major increase in the energy which can be practically radiated by an antenna because a larger portion of the modulated pulses' components have frequencies above the cut-off of the antenna.

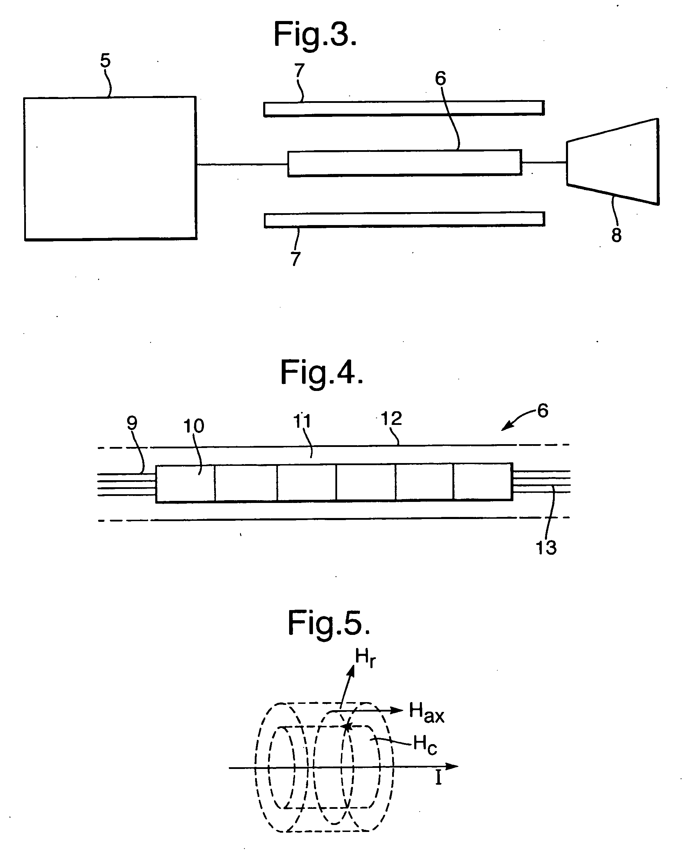

The apparatus in Figure 3 includes a high power video pulse generator 5. The pulse generator 5 produces a pumping impulse. The pumping impulse is a high power video signal with duration typically 1 to 10ns and a pulse rise time in the range of between 1 ps and 50ps. The voltage amplitude of this pumping impulse is dependent on the application and may be from less than 10kV to several 100kV. Such pulse generators are typically switched by hydrogen thyratrons or high power semiconductors and are produced by specialist companies including Kentech Ltd and FID Technologies GmbH. The pulse generator may also contain some form of electromagnetic shock line for pulse sharpening. The pumping impulse is injected into a non-linear transmission line 6 (for example a coaxial transmission line) which contains magnetic material 10 (see Figure 4) that is selected to support strong gyromagnetic characteristics. A magnetising structure 7 is provided around the outside of the transmission line 6 in order to apply bias to the magnetic material 10. The output of the non-linear transmission line 6 is fed into a suitable load structure 8 such as an antenna.

Figure 4 shows the structure of the coaxial transmission line 6. In this embodiment magnetic toroids 9 are placed coaxially around a central conductor 13 of the transmission line 6. Magnetic material 10 surrounds the toroids 9. The toroids 9 are in turn surrounded by high voltage insulating dielectric 11 such as polytetrafluroethylene (PTFE) and this is enclosed by the return conductor 12 of the transmission line 6.

Referring to Figure 5 a constant magnetic field $H_{ax}$ is generated by the magnetising structure 7 and this field is applied to the non-linear transmission line 6 in an axial or other orientation. The purpose of the constant magnetic field $H_{ax}$ is to align the magnetisation vector of the magnetic material 10 along a particular axis, typically the axial direction of the transmission line 6. The initial alignment of the magnetisations is a prerequisite for stimulation of gyromagnetic precession. Preferably, $H_{ax}$ is sufficient to cause 99.9% alignment of the magnetisations, although significant microwave output power may still be achieved for a lesser degree of alignment. The external source of magnetic field 7 may be a solenoid that is wound around the transmission line 6 or a suitably arranged collection of permanent magnets.

The pumping impulse produces a circumferential $I/2\pi r$ magnetic field $H_c$, where I is the pulse current and r is the mean radius of the magnetic material, in the transmission line 6, that rotates the magnetisation vector of the magnetic material 10 away from the initial direction toward the circumferential direction. The rate at which the magnetisation vector of the magnetic material 10 is rotated is dependent on the rise time of the pumping impulse, and the rise time of the pumping pulse should therefore be as short as possible. Preferably, the rise time is a fraction of a period of the resultant microwave waveform. The rise time will therefore be of the order to 1 to 50 ps in the present embodiment. A sufficiently short rise time to the pumping impulse will cause the magnetisation vector in the magnetic material 10 to gyromagnetically precess about the direction of the net applied magnetic field at a rate defined by the expression:

$$\frac{dM}{dt} = \gamma\mu_0 M \times H + \frac{\alpha}{M_s} \cdot M \times \frac{dM}{dt}$$

where; $\dfrac{dM}{dt}$ is the rate of change of Magnetisation in the Magnetic Material 10,
$\gamma$ is the Gyromagnetic Ratio,
$\mu_0$ is the Permeability of Free Space,
M is the Magnetisation of the Magnetic Material 10,
H is the Applied Magnetic Field,
$\alpha$ is the Damping Factor,
$M_s$ is the Saturation Magnetisation of the Magnetic Material 10.

Precession of the magnetisation vector of the magnetic material 10 provides an oscillatory magnetic field component in the transmission line 6. This processing field component in the magnetic material couples with the field of the pumping impulse to produce a modulation of the amplitude of the pumping impulse. The length of non-linear transmission line 6 required for the modulated signal to build up to its steady state amplitude is typically 5-50cm. The duration of the microwave modulation that can be developed in practice is typically in the region of 1 to 5ns for a single impulse.

The depth and duration of modulation of the pumping impulse are dependent on the gyromagnetic precession characteristics of the magnetic material 10 (usually ferrite or Yttrium Iron Garnet (YIG)), and also the dielectric and conductive loss mechanisms in the transmission line 6. The gyromagnetic precession is excited by the leading edge of the pumping impulse and persists for a time that is determined by damping and loss mechanisms both in the magnetic material 10 and in the transmission line structure 6. Lower loss rates give rise to higher modulation depths and longer decay periods. The primary contribution to decay of the precession is gyromagnetic damping in the magnetic material 10. In order to produce the longest microwave signal, it is therefore preferable to use materials with low gyromagnetic losses such as garnet-structured ferrite materials in single crystal or polycrystalline form. It is also preferable to reduce high frequency losses in the structure of the transmission line 6 by using low dielectric loss insulators 11 such as PTFE or polypropylene and also to minimise resistive dissipation in the transmission line 6 conductors by using high conductivity materials such as copper, silver or gold.

It is possible to tune the frequency output. The frequency of gyromagnetic precession is dependent on the properties of the magnetic material 10 that is used, on the amplitude of the constant axial magnetic field $H_{ax}$, on the amplitude of the pumping impulse and on the dimensions of the magnetic material and of the coaxial structure. The amplitude of the axial magnetic field $H_{ax}$ and/or the amplitude of the pumping impulse may therefore be used to adjust the frequency of the microwave modulation and hence to determine the spectral profile of the resultant output pulse.

The device may be applied in an ultra high repetition rate mode. The radiated power is determined by the product of pulse energy with pulse repetition rate. The radiated power can therefore be increased by increasing the pulse repetition rate. The maximum power and repetition rate are limited by thermal and cooling issues. The recovery time after a single forward pulse is of the order of 5ns. This means that it is feasible to drive the transmission line in burst mode at extremely high pulse repetition rates at up to the order of 100-200MHz or higher. Techniques for generating such pulse bursts may involve specialised semiconductor switching or the use of pulse forming network (PFN's).

A rapid succession of video pulses of either the same or alternating polarity can therefore be used to produce a rapid succession of microwave signals i.e. creating a train of quasi-continuous microwave bursts.

**Claims**

1. A Radio Frequency (RF) or microwave signal generator comprising a video pulse generator (5), a transmission line modulator (6) configured to modify the generated video pulses by impulse-excited gyromagnetic action to transfer a portion of the video pulses' energy from lower frequencies to a frequency output having frequencies in the RF or microwave range thereby producing a resultant RF or microwave waveform, **characterized in that** the transmission line (6) comprises a magnetic material (10) having low gyromagnetic damping.

2. A RF or microwave signal generator according to claim 1 **characterized in that** a magnetic field is applied to the transmission line (6).

3. A RF or microwave signal generator according to claim 2 **characterized in that** the magnetic field has a component ($H_{ax}$) axially orientated to the transmission line (6).

4. A RF or microwave signal generator as claimed in any preceding claim **characterized in that** the transmission line modulator (6) comprises a non-linear transmission line comprising a garnet structured ferrite material.

5. A RF or microwave signal generator as claimed in claim 4 **characterized in that** the magnetic material (10) is yttrium iron garnet.

6. A RF or microwave signal generator according to any preceding claim **characterized in that** the transmission line (6) comprises low dielectric loss insulators (11).

7. A RF or microwave signal generator according to any preceding claim **characterized in that** the transmission line (6) has conductors made from copper, silver or gold.

8. A RF or microwave signal generator according to any preceding claim **characterized in that** the impulse generator (5) produces a pumping impulse.

9. A RF or microwave signal generator according to any previous claim further **characterized by** comprising a frequency output tuner to adjust the frequency at which the video pulses are modulated.

10. A RF or microwave signal generator according to claim 8 **characterized in that** the pumping impulse has a rise time that is a fraction of the period of the resultant RF or microwave waveform.

11. A RF or microwave signal generator according to any preceding claim in combination with an antenna.

12. A method of generating Radio Frequency (RF) or microwave signals including the steps of:

   generating high power video impulses; and modifying the video pulses' energy from lower frequencies to frequencies in the RF or microwave range

   thereby producing a resultant waveform with an RF or microwave component, **characterized in that** the step of modifying the video pulses' energy comprises passing the video impulses through a transmission line (6) comprising a magnetic material (10) having low gyromagnetic damping.

13. A method according to claim 12 **characterized in that** the step of modifying the video pulses' energy comprises passing the video impulses through a transmission line (6) comprising a garnet structured ferrite material.

14. A method according to claim 13 further **characterized by** comprising the step of applying a magnetic field to the magnetic material, which magnetic field is orientated axially relative to the transmission line (6).

15. A method according to claim 14, **characterized in that** the magnetic material (10) is sufficiently strong to cause greater than 99% alignment of the magnetic moments of the magnetic material.

## Patentansprüche

1. Ein Hochfrequenz- (HF) oder Mikrowellensignalgenerator, der Folgendes beinhaltet: einen Videoimpulsgenerator (5), einen Übertragungsleitungsmodulator (6), der konfiguriert ist, um die erzeugten Videoimpulse durch impulserregte gyromagnetische Wirkung zu modifizieren, um einen Teil der Energie der Videoimpulse von niedrigeren Frequenzen in einen Frequenzausgang mit Frequenzen im HF- oder Mikrowellenbereich zu überführen, wodurch eine resultierende HF- oder Mikrowellenwellenform produziert wird, **dadurch gekennzeichnet, dass** die Übertragungsleitung (6) ein magnetisches Material (10) mit niedriger gyromagnetischer Dämpfung beinhaltet.

2. HF- oder Mikrowellensignalgenerator gemäß Anspruch 1, **dadurch gekennzeichnet, dass** ein Magnetfeld an die Übertragungsleitung (6) angelegt wird.

3. HF- oder Mikrowellensignalgenerator gemäß Anspruch 2, **dadurch gekennzeichnet, dass** das Magnetfeld eine Komponente ($H_{ax}$) aufweist, die zu der Übertragungsleitung (6) axial ausgerichtet ist.

4. HF- oder Mikrowellensignalgenerator gemäß einem der vorhergehenden Ansprüche, **dadurch gekennzeichnet, dass** der Übertragungsleitungsmodulator (6) eine nicht lineare Übertragungsleitung beinhaltet, die ein granatstrukturiertes Ferritmaterial beinhaltet.

5. HF- oder Mikrowellensignalgenerator gemäß Anspruch 4, **dadurch gekennzeichnet, dass** das magnetische Material (10) Yttrium-Eisen-Granat ist.

6. HF- oder Mikrowellensignalgenerator gemäß einem der vorhergehenden Ansprüche, **dadurch gekennzeichnet, dass** die Übertragungsleitung (6) Isolatoren (11) geringen dielektrischen Verlustes beinhaltet.

7. HF- oder Mikrowellensignalgenerator gemäß einem der vorhergehenden Ansprüche, **dadurch gekennzeichnet, dass** die Übertragungsleitung (6) aus Kupfer, Silber oder Gold gefertigte Leiter aufweist.

8. HF- oder Mikrowellensignalgenerator gemäß einem der vorhergehenden Ansprüche, **dadurch gekennzeichnet, dass** der Impulsgenerator (5) einen Pumpimpuls produziert.

9. HF- oder Mikrowellensignalgenerator gemäß einem der vorhergehenden Ansprüche, ferner **gekennzeichnet durch** Beinhalten eines Frequenzausgangsabstimmers, um die Frequenz, auf der die Videoimpulse moduliert werden, anzupassen.

10. HF- oder Mikrowellensignalgenerator gemäß Anspruch 8, **dadurch gekennzeichnet, dass** der Pumpimpuls eine Anstiegzeit aufweist, die ein Bruchteil der Periode der resultierenden HF- oder Mikrowellenwellenform ist.

11. HF- oder Mikrowellensignalgenerator gemäß einem der vorhergehenden Ansprüche in Kombination mit einer Antenne.

12. Ein Verfahren zum Erzeugen von Hochfrequenz- (HF) oder Mikrowellensignalen, das die folgenden Schritte umfasst:

    Erzeugen von Videoimpulsen hoher Leistung; und
    Modifizieren der Energie der Videoimpulse von niedrigeren Frequenzen zu Frequenzen im HF- oder Mikrowellenbereich,

    wodurch eine resultierende Wellenform mit einer HF- oder Mikrowellenkomponente produziert wird, **dadurch gekennzeichnet, dass** der Schritt des Modifizierens der Energie der Videoimpulse das Übermitteln der Videoimpulse durch eine Übertragungsleitung (6), die ein magnetisches Material (10) mit geringer gyromagnetischer Dämpfung beinhaltet, beinhaltet.

13. Verfahren gemäß Anspruch 12, **dadurch gekennzeichnet, dass** der Schritt des Modifizierens der Energie der Videoimpulse das Übermitteln der Videoimpulse durch eine Übertragungsleitung (6), die ein granatstrukturiertes Ferritmaterial beinhaltet, beinhaltet.

14. Verfahren gemäß Anspruch 13, ferner **gekennzeichnet durch** Beinhalten des Schrittes des Anlegens eines Magnetfeldes an das magnetische Material, wobei das Magnetfeld relativ zu der Übertragungsleitung (6) axial ausgerichtet ist.

15. Verfahren gemäß Anspruch 14, **dadurch gekennzeichnet, dass** das magnetische Material (10) ausreichend stark ist, um einen mehr als 99%igen Abgleich der magnetischen Momente des magnetischen Materials zu bewirken.

## Revendications

1. Un générateur de signaux radiofréquence (RF) ou micro-ondes comprenant un générateur d'impulsions vidéo (5), un modulateur de ligne de transmission (6) configuré pour modifier les impulsions vidéo générées par action gyromagnétique excitée par impulsions afin de transférer une portion de l'énergie des impulsions vidéo de fréquences plus basses à une sortie de fréquence ayant des fréquences dans la gamme RF ou micro-onde, produisant de ce fait une forme d'onde RF ou micro-onde résultante, **caractérisé en ce que** la ligne de transmission (6) comprend un matériau magnétique (10) à faible amortissement gyromagnétique.

2. Un générateur de signaux RF ou micro-ondes selon la revendication 1 **caractérisé en ce qu'**un champ magnétique est appliqué sur la ligne de transmission (6).

3. Un générateur de signaux RF ou micro-ondes selon la revendication 2 **caractérisé en ce que** le champ magnétique a une composante ($H_{ax}$) orientée de façon axiale par rapport à la ligne de transmission (6).

4. Un générateur de signaux RF ou micro-ondes tel que revendiqué dans n'importe quelle revendication précédente **caractérisé en ce que** le modulateur de ligne de transmission (6) comprend une ligne de transmission non linéaire comprenant un matériau ferrite à structure grenat.

5. Un générateur de signaux RF ou micro-ondes tel que revendiqué dans la revendication 4 **caractérisé en ce que** le matériau magnétique (10) est du grenat yttrium-fer.

6. Un générateur de signaux RF ou micro-ondes selon n'importe quelle revendication précédente **caractérisé en ce que** la ligne de transmission (6) comprend des isolateurs à faibles pertes diélectriques (11).

7. Un générateur de signaux RF ou micro-ondes selon n'importe quelle revendication précédente **caractérisé en ce que** la ligne de transmission (6) a des conducteurs réalisés à partir de cuivre, d'argent ou d'or.

8. Un générateur de signaux RF ou micro-ondes selon n'importe quelle revendication précédente **caractérisé en ce que** le générateur d'impulsions (5) produit une impulsion de pompage.

9. Un générateur de signaux RF ou micro-ondes selon n'importe quelle revendication précédente **caractérisé en outre en ce qu'**il comprend un syntoniseur de sortie de fréquence pour ajuster la fréquence à laquelle les impulsions vidéo sont modulées.

10. Un générateur de signaux RF ou micro-ondes selon la revendication 8 **caractérisé en ce que** l'impulsion de pompage a un temps de montée qui est une fraction de la période de la forme d'onde RF ou micro-onde résultante.

11. Un générateur de signaux RF ou micro-ondes selon n'importe quelle revendication précédente en combinaison avec une antenne.

12. Une méthode pour générer des signaux radiofréquence (RF) ou micro-ondes incluant les étapes consistant à :

générer des impulsions vidéo de force élevée ; et
modifier l'énergie des impulsions vidéo de fréquences plus basses à des fréquences dans la gamme RF ou micro-onde

produisant de ce fait une forme d'onde résultante avec une composante RF ou micro-onde, **caractérisé en ce que** l'étape consistant à modifier l'énergie des impulsions vidéo comprend le fait de faire passer les impulsions vidéo à travers une ligne de transmission (6) comprenant un matériau magnétique (10) ayant un amortissement gyromagnétique faible.

13. Une méthode selon la revendication 12 **caractérisée en ce que** l'étape consistant à modifier l'énergie des impulsions vidéo comprend le fait de faire passer les impulsions vidéo à travers une ligne de transmission (6) comprenant un matériau ferrite à structure grenat.

14. Une méthode selon la revendication 13 **caractérisée en outre en ce qu'**elle comprend l'étape consistant à appliquer un champ magnétique sur le matériau magnétique, lequel champ magnétique est orienté de façon axiale par rapport à la ligne de transmission (6).

15. Une méthode selon la revendication 14, **caractérisée en ce que** le matériau magnétique (10) est suffisamment fort pour causer un alignement supérieur à 99 % des moments magnétiques du matériau magnétique.

## Fig.1.

Video pulse

Modulated video pulse

## Fig.2.

Video

Modulated video

# Fig.3.

# Fig.4.

# Fig.5.

## REFERENCES CITED IN THE DESCRIPTION

**Non-patent literature cited in the description**

- **SHAW H.J. ; ELLIOTT, B.J. ; HARKER K.J. ; KARP A.** Microwave generation in pulsed ferrites. *J. App. Phys.,* 1966, vol. 37 (3
- **DOLAN J E.** Simulation of Shock Waves in Ferrite-Loaded Coaxial Transmission Lines with Axial Bias. *Journal of Physics D and Applied Physics,* 07 August 1999, vol. 32 (15), 1826-1831

- **KATAYEV, I.G.** Electromagnetic shock waves. Iliffe Books Ltd, 1966
- **WEINER M. ; SILBER L.** Pulse sharpening effects in ferrites. *IEEE Trans Magn,* 1981, vol. MAG-17, 1472-1477